# FASCICULE DE BREVET EUROPEEN

(11) **EP 4 178 051 B1**
(45) Date de publication et mention de la délivrance du brevet: **15.05.2024**
(21) Numéro de dépôt: 22206233.3
(22) Date de dépôt: 08.11.2022
(51) Int. Cl.: H01S 5/02, H01S 5/024, H01S 5/026, H01S 5/028, H01S 5/042, H01S 5/10

(54) **PROCÉDÉ D'INTÉGRATION SUR SILICIUM D'UN COMPOSANT III-V ET COMPOSANT III-V INTÉGRÉ SUR SILICIUM**
VERFAHREN ZUR INTEGRATION EINER III-V-KOMPONENTE AUF SILIZIUM UND AUF SILIZIUM INTEGRIERTE III-V-KOMPONENTE
METHOD FOR INTEGRATING A III-V COMPONENT ON SILICON AND III-V COMPONENT INTEGRATED ON SILICON

(30) Priorité: 09.11.2021 FR 2111895
(43) Date de publication de la demande: 10.05.2023
(73) Titulaire: Commissariat à l'Energie Atomique et aux Energies Alternatives, 75015 Paris (FR); THALES, 92400 Courbevoie (FR)
(72) Inventeur: NEEL, Delphine, 91767 Palaiseau Cedex (FR); BITAULD, David, 91767 Palaiseau Cedex (FR)
(74) Mandataire: Hautier IP

(56) Documents cités:
- EP-A1- 2 866 313
- EP-A1- 3 642 914
- US-A1- 2017 047 312
- US-A1- 2019 074 664
- US-A1- 2021 143 609
- US-B1- 9 941 664
- ZHANG CHONG ET AL: "Thermal Management of Hybrid Silicon Ring Lasers for High Temperature Operation", IEEE JOURNAL OF SELECTED TOPICS IN QUANTUM ELECTRONICS, IEEE, USA, vol. 21, no. 6, 1 novembre 2015 (2015-11-01), pages 1-7, XP011585819, ISSN: 1077-260X, DOI: 10.1109/JSTQE.2015.2428057 [extrait le 2015-06-26]

## Description

### DOMAINE TECHNIQUE

Le domaine de l'invention est celui de la photonique intégrée sur puce. L'invention concerne plus particulièrement la réalisation de composants à base de matériaux III-V, par exemple des lasers ou des modulateurs de phase, sur une puce microélectronique à base de silicium.

### ETAT DE LA TECHNIQUE

Dans le domaine de la photonique, l'une des voies de développement les plus prometteuses concerne l'hétérointégration de composants à base de matériaux III-V sur une puce microélectronique à base de silicium. Cette hybridation technologique permet de bénéficier à la fois des performances optoélectroniques des composants III-V, et des avantages et performances des composants silicium.

Une telle hybridation se fait typiquement par report d'un substrat ou d'un composant à base de matériau III-V sur un substrat ou un composant à base de silicium. Après collage, d'autres étapes de procédé permettent de fonctionnaliser l'ensemble, par exemple afin d'obtenir un laser III-V piloté par une électronique de commande CMOS issue de la technologie silicium (CMOS signifiant « Complementary Metal Oxide Semiconductor », en référence à la technologie basée sur des transistors MOS complémentaires de type N et P).

L'un des enjeux lié à cette hybridation porte sur la dissipation de la chaleur produite lors du fonctionnement des composants III-V. L'empilement de différents niveaux présentant des fonctions différentes, typiquement un niveau de guidage optique à base de silicium, un niveau d'interconnexions, un niveau CMOS, rend la gestion de la dissipation thermique complexe. Les différents éléments intégrés autour des composants III-V doivent être pris en compte dans la conception d'une architecture thermiquement efficace.

Par exemple, une couche d'oxyde enterrée BOX (acronyme de « Burried Oxide ») épaisse forme une barrière d'isolation thermique et empêche une bonne dissipation thermique. Il faut en outre éviter que la dissipation thermique se fasse au travers des composants CMOS, dont les performances se dégradent lorsqu'ils sont excessivement chauffés.

Le document EP3642914A1 divulgue une architecture où le laser III-V est disposé au plus près d'une couche de dissipation thermique à base de silicium issue d'un substrat silicium. De façon connue, cette architecture comprend ainsi successivement en empilement : la couche de dissipation thermique à base de silicium, le laser III-V, un guide d'onde en silicium, un niveau d'interconnexions, une électronique de commande.

La proximité du laser avec la couche de dissipation thermique améliore le refroidissement du laser. La disposition de l'électronique de commande à l'opposé de la couche de dissipation thermique évite que l'électronique de commande soit impactée par la chaleur dissipée du laser. Cette solution n'est cependant pas optimale. Les flux de dissipation thermique restent limités. La puissance optique d'un tel composant reste encore limitée.

Il existe donc un besoin consistant à améliorer la dissipation thermique d'un composant III-V hybridé sur silicium. Un objectif de la présente invention est de répondre à ce besoin.

Un objet de la présente invention concerne un composant III-V sur silicium présentant une dissipation thermique améliorée.

Un autre objet de la présente invention concerne un procédé de fabrication d'un tel composant III-V sur silicium.

Les autres objets, caractéristiques et avantages de la présente invention apparaîtront à l'examen de la description suivante et des dessins d'accompagnement.

### RESUME

Pour atteindre cet objectif, selon un mode de réalisation on prévoit un procédé d'intégration sur silicium d'un composant à base de matériau III-V, dit composant III-V, comprenant au moins les étapes suivantes :
- Fournir un premier substrat comprenant une couche optique à base de silicium, ladite couche optique comprenant au moins un guide d'onde,
- Reporter un deuxième substrat à base de matériau III-V sur la couche optique,
- Former le composant III-V à partir dudit deuxième substrat, à proximité du guide d'onde de sorte à permettre un couplage entre le guide d'onde et ledit composant III-V, et en conservant une couche à base de matériau III-V s'étendant latéralement depuis le composant III-V,
- Former par épitaxie à partir de ladite couche à base de matériau III-V, une structure à base d'InP:Fe bordant latéralement le composant III-V,
- Former une couche comprenant des contacts, dits contacts III-V et destinés à contacter électriquement le composant III-V, sur une face du composant III-V opposée à la couche optique,
- Reporter un troisième substrat à base de silicium sur ladite couche comprenant les contacts III-V,
- Retirer de préférence le premier substrat en conservant la couche optique,
- Former de préférence au moins un niveau d'interconnexions sur la couche optique, ledit niveau d'interconnexions comprenant des interconnexions connectant électriquement les contacts III-V.

Ainsi, le troisième substrat à base de silicium forme une couche de dissipation thermique, et la couche optique comprenant le guide d'onde, et le niveau d'interconnexions sont disposés à l'opposé de cette couche de dissipation thermique, vis-à-vis du composant III-V.

Avantageusement, la structure à base d'InP:Fe bordant le composant III-V forme une structure de dissipation thermique autour du composant III-V, et en regard de la couche de dissipation thermique formée par le troisième substrat. Cela améliore considérablement les flux de dissipation thermique entre le composant III-V et la couche de dissipation thermique.

Contrairement à l'oxyde de silicium utilisé comme matériau d'isolation autour du composant III-V dans l'architecture divulguée par le document EP3642914B1, la structure de dissipation thermique à base d'InP:Fe est ici spécifiquement choisie pour fournir une bonne isolation électrique et une bonne conduction thermique. Une telle structure est également dénommée structure semi-isolante ou SIBH (acronyme de « semi-insulating buried heterostructure » soit hétérostructure enterrée semi-isolante en français) dans la suite.

Selon un mode de réalisation avantageux, le retrait du premier substrat est effectué de façon à exposer la couche optique et/ou le guide d'onde. Une implantation est alors effectuée, après retrait du premier substrat, dans une zone à base de silicium de la couche optique. Cela permet de former des zones de silicium dopées après avoir réalisé la structure SIBH. Un modulateur de phase à jonction PN peut ainsi être formé, après formation de la structure SIBH et avant formation du niveau d'interconnexions.

Une telle structure SIBH est typiquement formée par épitaxie à des températures supérieures ou égales à 600 °C. De telles températures sont généralement incompatibles avec certaines étapes de procédé spécifiques aux composants à base de silicium, typiquement pour les composants nécessitant un dopage localisé du silicium par implantation. A de telles températures, les dopants diffusent en dehors des zones de silicium dopées. La formation de SIBH est donc incompatible avec un dopage préalable. La formation d'une jonction PN, par exemple d'un modulateur de phase, dans la couche optique comprenant le guide d'onde, telle qu'enseignée par le document EP3642914A1 est donc incompatible avec la mise en oeuvre du procédé ici présenté.

L'architecture ainsi obtenue par la mise en oeuvre du procédé présente donc une dissipation thermique améliorée par rapport à l'architecture connue du document EP3642914A1, tout en permettant d'intégrer des composants à base de silicium dopé.

Selon un autre aspect, un système d'intégration présentant une telle architecture de composant III-V intégré sur un substrat silicium est proposé.

Selon un mode de réalisation, le système d'intégration comprend, en empilement selon une direction z :
- Un substrat à base de silicium,
- Une couche comprenant des contacts, dits contacts III-V, destinés à contacter électriquement un composant à base de matériau III-V, dit composant III-V,
- Le composant III-V bordé latéralement par une structure à base d'InP:Fe,
- Une couche à base de matériau III-V couvrant le composant III-V et la structure à base d'InP:Fe,
- Une couche optique à base de silicium comprenant un guide d'onde couplé au composant III-V,
- De préférence, un niveau d'interconnexions comprenant une première partie d'interconnexions connectant électriquement les contacts III-V, et une deuxième partie d'interconnexions destinée à connecter des composants à base de silicium disposés sur ledit niveau d'interconnexions.

Ce système d'intégration présente également les avantages indiqués plus haut liés à la dissipation thermique, et la possibilité de connecter ou d'intégrer facilement des composants à base de silicium, telle qu'une électronique de commande. La chaleur produite par le composant III-V en fonctionnement est avantageusement dissipée au travers de la structure à base d'InP:Fe et du substrat à base de silicium. Le niveau d'interconnexions situé à l'opposé du substrat à base de silicium, vis-à-vis du composant III-V, permet d'intégrer des connexions avec différents composants, typiquement à base de silicium, en étant protégé de la chaleur issue du composant III-V.

Selon une possibilité, la couche optique de ce système d'intégration comprend d'autres composants à base de silicium, par exemple un modulateur de phase à jonction PN connecté via le niveau d'interconnexions.

Les autres objets, caractéristiques et avantages apparaîtront à l'examen de la description suivante et des dessins d'accompagnement. Il est entendu que d'autres avantages peuvent être incorporés. En particulier, certaines caractéristiques et certains avantages du procédé d'intégration peuvent s'appliquer *mutatis mutandis* au système d'intégration, et réciproquement.

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
Les figures 1A à 1N illustrent schématiquement en coupe transverse des étapes de réalisation d'un système d'intégration selon un mode de réalisation de la présente invention.
La figure 2 illustre schématiquement en coupe transverse un système d'intégration selon un autre mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les dimensions des différents éléments (composants, interconnexions, couches et niveaux, électroniques de commande...) ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, le procédé comprend en outre, après report du troisième substrat à base de silicium, les étapes suivantes :
- Retirer le premier substrat en conservant la couche optique,
- Former au moins un niveau d'interconnexions sur la couche optique, ledit niveau d'interconnexions comprenant des interconnexions connectant électriquement les contacts III-V.

Selon un exemple, le retrait du premier substrat est effectué de façon à exposer la couche optique, le procédé comprenant en outre, après retrait du premier substrat, un dopage d'une zone à base de silicium de la couche optique. Le dopage peut typiquement se faire par implantation d'espèces dopantes, suivie d'un recuit thermique d'activation.

Selon un exemple, le procédé comprend en outre, avant implantation d'espèces dopantes, au moins une autre étape effectuée à une température supérieure ou égale à 600°C.

Selon un exemple, le premier substrat est un substrat du type semiconducteur sur isolant, comprenant une couche d'oxyde enterrée entre une première partie massive en silicium et une deuxième partie mince à base d'un semiconducteur. Le semiconducteur peut être typiquement pris parmi les semiconducteurs IV-IV, notamment le silicium, le germanium, le silicium-germanium.

Selon un exemple, le retrait du premier substrat est configuré pour retirer la première partie massive en silicium et la couche d'oxyde enterrée.

Selon un exemple, la formation du composant III-V comprend :
- Un amincissement du deuxième substrat à base de matériau III-V de sorte à conserver une couche de germination à base de matériau III-V,
- Une formation du composant III-V par épitaxie localisée sur une partie seulement de la couche de germination.

Selon un exemple, la formation du composant III-V comprend :
- Un amincissement du deuxième substrat à base de matériau III-V de sorte à conserver une couche de germination à base de matériau III-V,
- Une formation par épitaxie d'un empilement de couches fonctionnelles à base de matériau III-V, sur la couche de germination,
- Une gravure d'une partie de l'empilement de sorte à former le composant III-V et la couche à base de matériau III-V s'étendant latéralement depuis le composant III-V.

Selon un exemple, le deuxième substrat à base de matériau III-V comprend une couche sacrificielle intercalée entre une partie dite massive du deuxième substrat et une partie destinée à former la couche de germination.

Selon un exemple, l'amincissement comprend :
- Au moins l'un parmi un rognage mécanique de la partie massive du deuxième substrat et/ou une gravure chimique sélective de la partie massive du deuxième substrat vis-à-vis de la couche sacrificielle,
- Une gravure sélective de la couche sacrificielle vis-à-vis de la couche destinée à former la couche de germination.

Selon un exemple, la gravure chimique sélective de la partie massive du deuxième substrat vis-à-vis de la couche sacrificielle est effectué par gravure humide à base d'un mélange d'acide chlorhydrique (HCl) et d'acide phosphorique (H3PO4), par exemple dans des proportions HCl:H3PO4 de 1:10.

Selon un exemple, la formation du composant III-V comprend une formation de puits quantiques à base d'un alliage AlInGaAs ou InGaAsP.

Selon un exemple, le procédé comprend en outre, avant report du troisième substrat, une formation d'une couche de conduction thermique sur l'un au moins parmi la couche comprenant les contacts III-V et le troisième substrat, de façon à intercaler ladite couche de conduction thermique entre le troisième substrat et la couche comprenant les contacts III-V.

Selon un exemple, la couche à base de matériau III-V s'étendant latéralement depuis le composant III-V est à base d'InP dopé N.

Selon un exemple, le système d'intégration comprend en outre, sur la couche optique à base de silicium, un niveau d'interconnexions comprenant une première partie d'interconnexions connectant électriquement les contacts III-V, et une deuxième partie d'interconnexions destinée à connecter des composants à base de silicium disposés sur ledit niveau d'interconnexions.

Selon un exemple, la couche optique comprend en outre au moins un autre composant à base de silicium, par exemple un modulateur de phase à jonction PN, connecté au niveau d'interconnexions.

Selon un exemple, la couche à base de matériau III-V couvrant le composant III-V est à base d'InP dopé N.

Selon un exemple, le composant III-V comprend une partie à base d'InP dopé P, et des puits quantiques à base d'un alliage AlInGaAs ou GaInAsP intercalés entre la partie à base d'InP dopé P et la couche à base d'InP dopé N.

Sauf incompatibilité, des caractéristiques techniques décrites en détail pour un mode de réalisation donné peuvent être combinées aux caractéristiques techniques décrites dans le contexte d'autres modes de réalisation décrits à titre exemplaire et non limitatif, de manière à former un autre mode de réalisation qui n'est pas nécessairement illustré ou décrit. Un tel mode de réalisation n'est évidemment pas exclu de l'invention.

Dans le cadre de la présente invention, une structure de dissipation thermique est mise en oeuvre. Cette structure peut également assurer une fonction d'isolation électrique. Elle peut ainsi être désignée comme structure « semi-isolante », dans le sens où cette structure présente une faible conductivité électrique, mais une forte conductivité thermique. Typiquement, la résistivité électrique d'une telle structure est supérieure à 10⁷ Ω.cm, par exemple de l'ordre de 10⁸ Ω.cm pour une structure à base d'InP:Fe. Typiquement, la conductivité thermique d'une telle structure est supérieure à 0,5 W.cm⁻¹.K⁻¹, par exemple de l'ordre de 0.68 W.cm⁻¹.K⁻¹ pour une structure à base d'InP:Fe.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, un élément, une couche, « à base » d'un matériau A, un substrat, un élément, une couche comprenant ce matériau A uniquement ou ce matériau A et éventuellement d'autres matériaux, par exemple des éléments d'alliage et/ou des éléments dopants. Ainsi, un substrat « à base de silicium » peut comprendre une partie massive en silicium, et une couche mince en silicium ou en germanium, ou en alliage SiGe. Une couche optique « à base de silicium » peut comprendre un premier élément en silicium, et/ou un deuxième élément en germanium, et/ou un troisième élément en SiGe. Une couche « à base d'InP » peut comprendre de l'InP, de l'InP:Fe comprenant des impuretés Fe, de l'InP dopé N ou P.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B.

Un repère de préférence orthonormé, comprenant les axes x, y, z est représenté sur les figures annexées. Lorsqu'un seul repère est représenté sur une même planche de figures, ce repère s'applique à toutes les figures de cette planche.

Les termes relatifs tels que « sur », « surmonte », « sous », « sous-jacent », « au-dessus », « en-dessous » se réfèrent à des positions prises selon la direction z. Cette liste de termes n'est pas exhaustive. D'autres termes relatifs pourront être facilement précisés au besoin, en se référant aux dessins d'accompagnement.

Dans la présente demande de brevet, la hauteur et la profondeur sont prises selon z.

Les termes « vertical », « verticalement » se réfèrent à une direction selon z. Les termes « horizontal », « horizontalement » se réfèrent à une direction dans le plan xy. Les termes « latéral », « latéralement », lorsqu'il s'agit d'un déplacement, d'une extension ou d'un positionnement, se réfèrent également à une direction dans le plan xy, typiquement la direction x.

Un élément situé « à l'aplomb » ou « au droit d'» un autre élément signifie que ces deux éléments sont situés tous deux sur une même ligne orientée verticalement sur les figures. Cela ne signifie pas nécessairement que ces deux éléments sont centrés par rapport à un axe vertical.

On entend par matériau III-V, un alliage comprenant des éléments des colonnes IIIB et VB du tableau périodique des éléments (bloc p).

De façon non limitative, les matériaux III-V mis en oeuvre dans le procédé et le système d'intégration comprennent : l'InP, l'AIN, de l'InGaAs, de l'AlInGaAs.

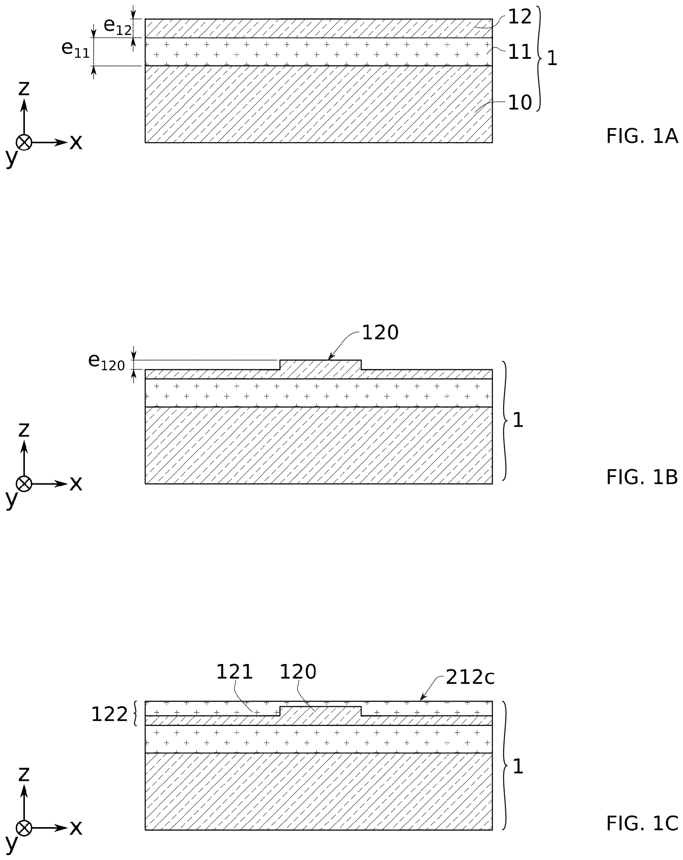

Les figures 1A à 1N illustrent un mode de réalisation d'une architecture permettant l'hétérointégration d'un composant III-V couplé à un guide d'onde en silicium, avec une dissipation thermique améliorée.

Comme illustré en figure 1A, un premier substrat 1 de type silicium sur isolant SOI (acronyme de Silicon On Insulator) est typiquement fourni. Ce substrat 1 comprend typiquement en empilement selon z une partie 10 massive en silicium dite bulk, une couche d'oxyde enterrée 11 dite BOX, et une couche superficielle 12 également dénommée top Si.

L'épaisseur e₁₁ du BOX 11 est typiquement de l'ordre de 1 µm à 2 µm. L'épaisseur e₁₂ du top Si 12 est typiquement de l'ordre de 300nm à 600nm, par exemple environ 500nm. Cette épaisseur e₁₂ de 500nm peut être obtenue par recroissance de silicium à partir d'une couche mince de silicium d'un substrat SOI présentant une épaisseur de top Si standard de 100 nm ou 200 nm.

Comme illustré en figure 1B, la couche 12 de top Si est gravée sur une profondeur e₁₂₀ typiquement comprise entre 200nm et 300 nm, de manière à former une structure de guide d'onde 120 en arête.

Comme illustré en figure 1C, la structure obtenue est ensuite recouverte par une couche d'encapsulation 121 à base d'oxyde de silicium, avant d'être planarisée de façon connue par polissage mécano-chimique (CMP). Cela permet d'obtenir un état de surface compatible avec le collage d'une autre plaquette ou substrat également dénommés wafer. La couche d'encapsulation 121 et la partie restante du top Si 12 comprenant le guide d'onde 120 forment une couche optique 122. La couche optique 122 présente ainsi une surface 212c à base d'oxyde de silicium SiO2. Le guide d'onde 120 est typiquement enterré sous la surface 212c à une profondeur de l'ordre de 10 nm à 150 nm.

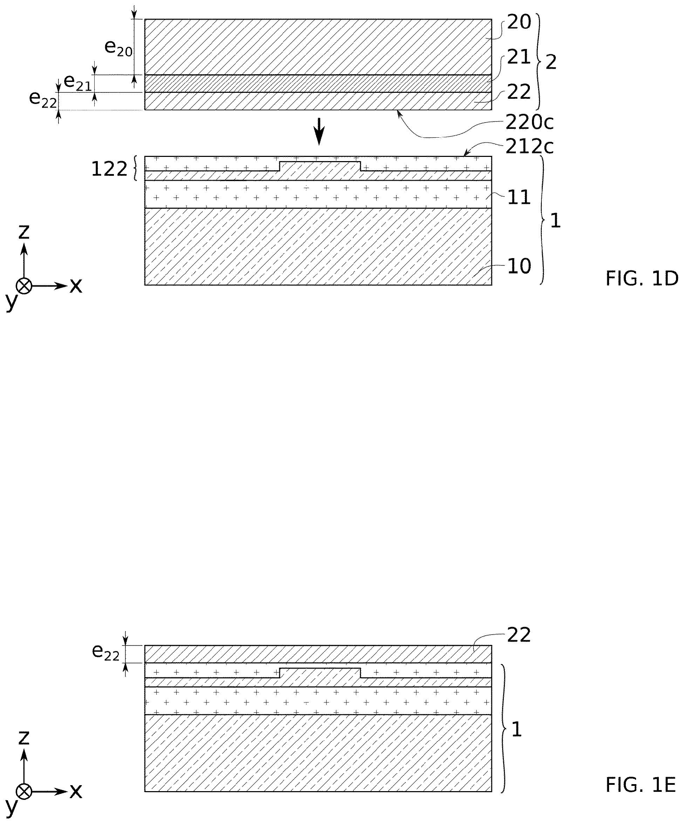

Comme illustré en figure 1D, un deuxième substrat 2 est amené en regard de la couche optique 122. Ce substrat 2 comprend typiquement en empilement selon z une fine couche de germination 22 à base d'InP, une couche sacrificielle 21 à base d'InGaAs, et une partie 20 massive à base d'InP.

L'épaisseur e₂₂ de la couche de germination 22 est typiquement de l'ordre de 100nm à 300 nm. L'épaisseur e₂₁ de la couche sacrificielle 21 est typiquement de l'ordre de 200nm à 400nm. L'épaisseur e₂₀ de la partie 20 massive peut être de l'ordre de quelques microns à quelques dizaines de microns, voire à quelques centaines de microns.

Cet empilement de couches à base de matériau III-V est tourné de façon à présenter la couche de germination 22 en regard de la couche optique 122, puis collé, par exemple par collage direct hydrophile. Pour ce type de collage, les surfaces 220c, 212c sont rendues hydrophiles par des traitements de surface adaptés. La surface 220c de la couche de germination 22 à base INP est typiquement préalablement nettoyée par une solution à base d'acide fluorhydrique, puis exposée à un plasma d'oxygène et/ou d'ozone. La surface 212c à base de SiO2 de la couche optique 122 est typiquement exposée à un plasma d'oxygène et/ou d'ozone. Après assemblage des surfaces 220c, 212c ainsi préparées, un recuit thermique de l'ordre de 300° est effectué de façon à finaliser ce collage direct hydrophile.

Comme illustré en figure 1E, après collage, la partie 20 massive à base d'InP est d'abord retirée, puis la couche sacrificielle 21 est retirée sélectivement à la couche de germination 22. Le retrait de la partie 20 massive peut se faire par rognage mécanique et/ou par gravure chimique. Le retrait de la couche sacrificielle 21 se fait de préférence par gravure sélective de l'InGaAs vis-à-vis de l'InP, par exemple par gravure humide à base d'un mélange d'acide sulfurique (H2SO4), d'eau oxygénée (H2O2) et d'eau (H2O), par exemple dans des proportions H2SO4:H2O2:H2O de 1:1:20.

La couche de germination 22 ainsi exposée permet d'effectuer une recroissance par épitaxie d'un matériau III-V d'excellente qualité cristalline.

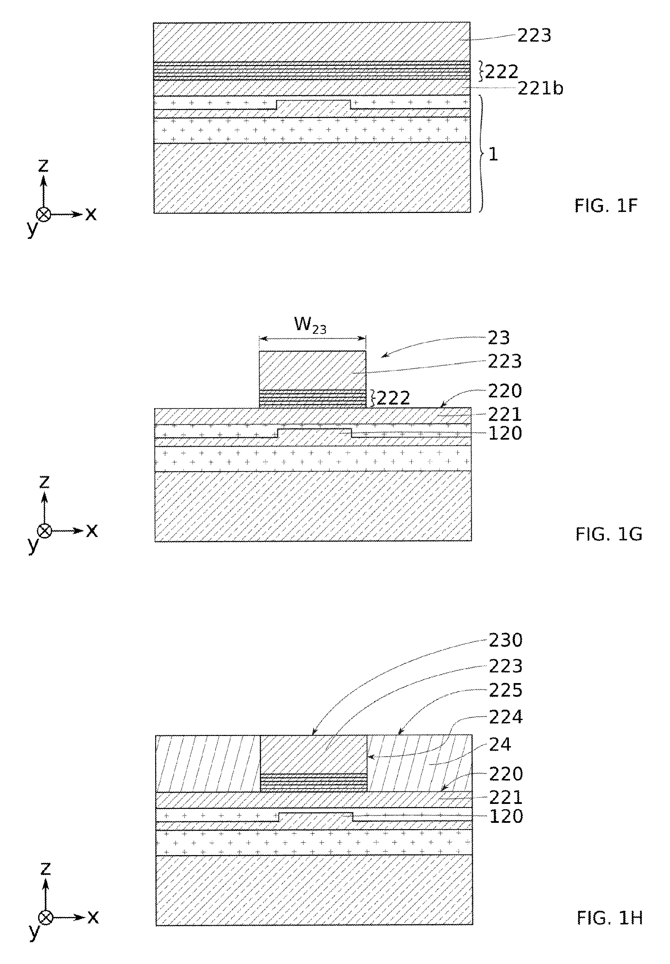

Comme illustré en figure 1F, une croissance d'une structure de composant laser III-V peut être avantageusement effectuée sur cette couche de germination 22. De façon préférée, une croissance d'InP dopé N est effectuée de manière à obtenir la couche de base 221b. Des puits quantiques à base d'AlInGaAs sont ensuite épitaxiés sur cette couche de base 221b, de façon à former la région active 222. La région active 222 peut typiquement comprendre un nombre de puits quantiques compris entre 3 et 20, par exemple 8. Une couche 223 à base d'InP dopé P est ensuite épitaxiée. D'autres couches, par exemple une couche de contact P à base d'InGaAs, peuvent également être crues sur ou au sein de cet empilement, de façon à améliorer l'injection des porteurs de charge par exemple.

Ces étapes de croissance de matériau III-V sont typiquement effectuées par Epitaxie en Phase Vapeur à partir de précurseurs Organo-Métalliques (MOVPE) à des températures de croissance supérieures ou égales à 600°C. Les précurseurs organo-métalliques pouvant être utilisés sont par exemple le Triméthylaluminium (TMAI), le Triméthylgallium (TMGa), le Triméthylindium (TMIn). Les sources d'éléments V peuvent être des hydrures (AsH3, PH3). Ces croissances sont de préférence effectuées de façon localisées sur le premier substrat 1, par des techniques dites SAG (acronyme de « Sélective Area Growth », soit « croissance localisée » en français).

Comme illustré en figure 1G, la couche 223 dopée P et la région active 222 sont typiquement gravées de manière à former un composant 23 présentant une structure en arête de largeur w₂₃ selon x. La largeur w₂₃ est typiquement comprise entre 500 nm et 3 µm. Ce composant 23 est par exemple un laser à base de matériau III-V. Ce laser peut être de type Fabry-Pérot, ou à miroirs de Bragg distribués, ou avec une cavité en anneaux. La gravure est configurée de manière à ce que le composant 23 soit optiquement couplé avec le guide d'onde 120. Le composant 23 peut être ainsi sensiblement centré vis-à-vis du guide d'onde 120 selon x. Selon un exemple, le composant 23 et le guide d'onde 120 sont à l'aplomb l'un de l'autre. Selon une possibilité, le composant III-V peut être un modulateur de phase électro-optique.

Après gravure, une couche 221 issue de la couche de base 221b s'étend typiquement de part et d'autre de la structure en mésa 222, 223 du composant 23. Cette couche 221 est typiquement destinée à former une couche d'injection pour le contact de type N. Elle présente une surface 220 exposée. Avantageusement, cette couche 221 permet d'effectuer une épitaxie d'InP:Fe de part et d'autre du composant 23.

Le composant 23 peut typiquement comprendre la couche d'injection 221, la région active 222, la couche 223, et éventuellement une partie du guide d'onde 120.

Comme illustré à la figure 1H, une structure 24 à base d'InP:Fe est formée à partir de la couche 221, en bordure du composant 23. La structure 24 est typiquement formée par MOVPE à une température supérieure ou égale à 600°C. Cette structure 24 est de préférence directement au contact des flancs 224 du composant 23. Selon une autre possibilité une fine couche, également appelée liner, peut être intercalée entre la structure 24 et les flancs 224. Cette structure 24 forme avantageusement une structure de dissipation thermique SIBH pour le composant 23. Après croissance de l'InP:Fe sur la couche 221, une planarisation, par exemple par polissage mécano-chimique, est de préférence effectuée de façon à exposer le sommet 230 du composant 23. Une surface plane 230, 225 est ainsi obtenue.

Selon une possibilité alternative, le composant 23 est formé séparément, avec ou sans la structure de dissipation thermique SIBH, et directement reporté sur la couche optique 122. Le nombre d'étapes de croissance à haute température de matériaux III-V peut ainsi être limité. Après report, le guide d'onde 120 peut être en partie structuré, par exemple selon la direction y.

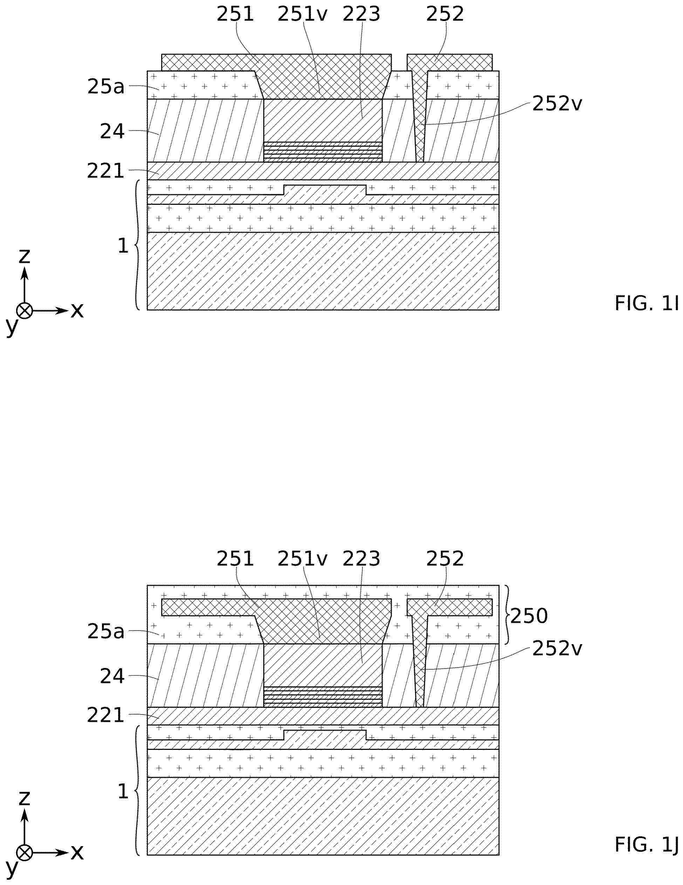

Comme illustré à la figure 1I, de façon optionnelle, une couche d'encapsulation 25a à base de SiO2 peut être déposée sur la surface plane 230, 225 du niveau III-V, puis planarisée. Des contacts N et P sont ensuite formés sur le composant 23. La partie 223 dopée P du composant 23 est ainsi contactée électriquement à un contact P 251, par l'intermédiaire d'un via métallique 251v. La couche 221 dopée N reliant le composant 23 est ainsi contactée électriquement à un contact N 252, par l'intermédiaire d'un via métallique 252v. Le via 252v traverse la structure de dissipation thermique 24 et optionnellement la couche d'encapsulation 25a.

Comme illustré à la figure 1J, après formation des vias 251v, 252v et des contacts P et N 251, 252, une deuxième couche d'encapsulation 25b à base de SiO2 est déposée puis planarisée. Une couche 250 comprenant un premier niveau de contacts électriques est ainsi formée.

Selon une possibilité, les couches d'encapsulation 25a, 25b peuvent être à base d'un matériau électriquement isolant et bon conducteur thermique, par exemple le nitrure d'aluminium AIN.

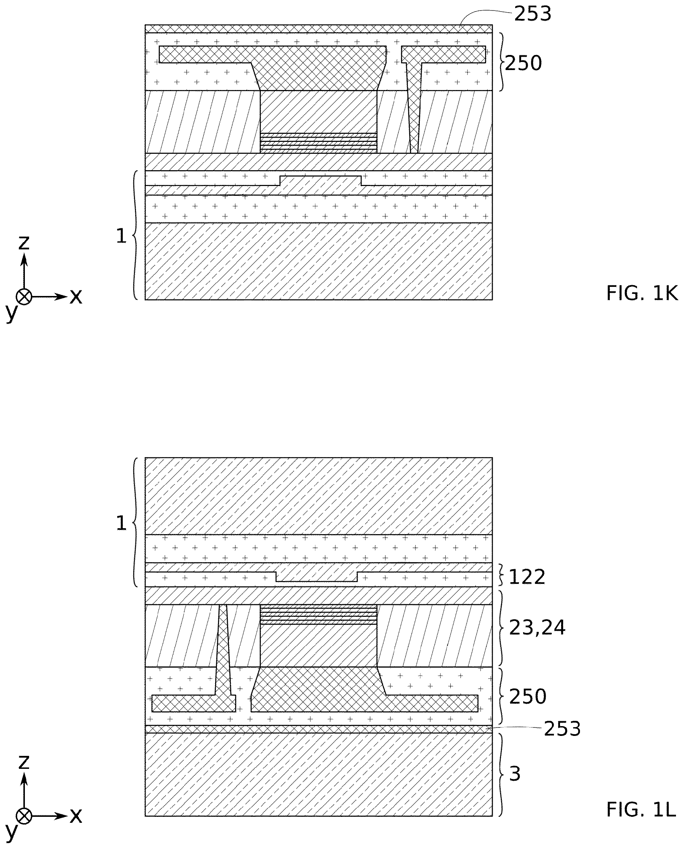

De façon optionnelle, comme illustré à la figure 1K, une couche de conduction thermique 253 peut être déposée sur la couche de contacts 250. Cette couche de conduction thermique 253 présente typiquement une conduction thermique élevée. Elle peut être électriquement conductrice, par exemple à base d'un métal compatible avec la technologie CMOS. Une telle couche de conduction thermique 253, par exemple à base d'or, peut également faciliter l'assemblage avec un autre wafer.

Comme illustré à la figure 1L, un troisième substrat 3, typiquement à base de silicium, est assemblé en regard de la couche de contacts 250, éventuellement par l'intermédiaire de la couche de conduction thermique 253.

À ce stade, la structure ainsi formée comprend en empilement selon z :
- le premier substrat 1 comprenant la couche optique 122 à base de silicium,
- un niveau III-V comprenant le composant 23 et la structure de dissipation thermique 24, et possiblement un ou plusieurs vias traversants,
- une couche de contacts 250,
- de façon optionnelle, une couche de conduction thermique 253,
- un troisième substrat 3 à base de silicium.

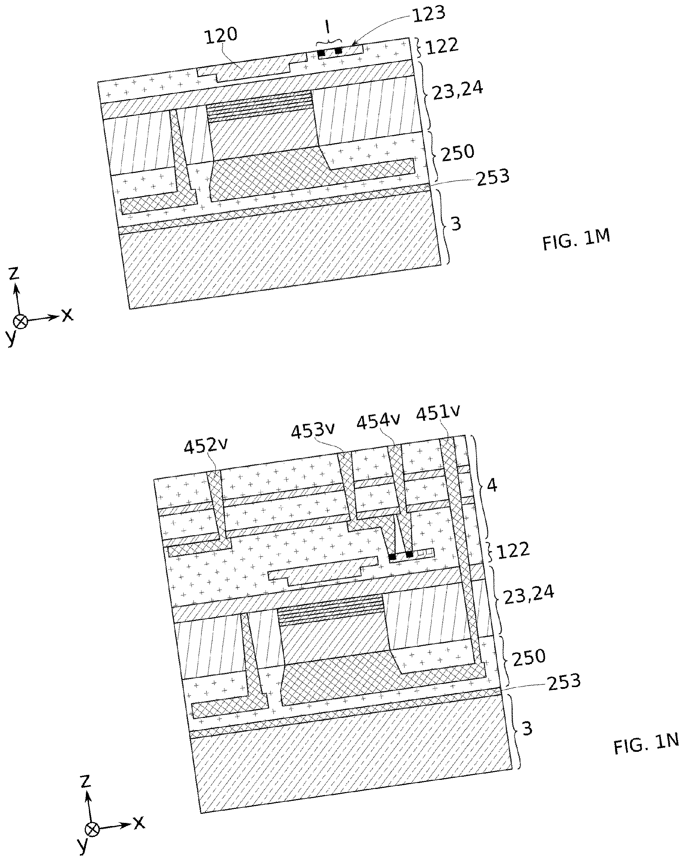

Comme illustré à la figure 1M, le substrat 1 est alors en partie retiré. En particulier, la partie bulk et le BOX sont retirés par rognage et gravure chimique, de façon à exposer la partie restante du top Si de la couche optique 122.

Cette partie du top Si peut être avantageusement de nouveau structurée par lithographie/gravure de façon à former un composant à base de silicium 123. De façon avantageuse, une implantation d'espèces dopantes peut être effectuée au niveau d'une zone d'implantation I. Une activation des espèces dopantes par recuit thermique est alors typiquement réalisée. Le retrait préalable du BOX permet notamment de réaliser une telle implantation. Cela permet également de réaliser un dopage par diffusion, selon une possibilité alternative. Un composant 123 présentant des zones implantées et dopées est ainsi avantageusement obtenu. Un tel composant 123 à base de silicium peut être par exemple un modulateur de phase à jonction PN, un autre guide d'onde. Selon une autre possibilité, le BOX est partiellement retiré et aminci de façon à permettre une implantation d'espèces dopantes dans la zone d'implantation I au travers du BOX aminci. Le dopage localisé du top Si est ainsi avantageusement effectué après l'étape d'épitaxie d'InP:Fe nécessitant un grand budget thermique. La ou les étapes d'épitaxie haute température (SAG, SIBH) ne perturbent donc pas le dopage du top Si. Cela permet de mieux contrôler les profils de dopage dans le top Si.

Comme illustré à la figure 1N, un ou plusieurs niveaux d'interconnexions 4 peuvent être formés sur la couche optique 122, par des procédés conventionnels de fin de ligne BEOL (acronyme de « Back End Of Line »). Dans l'exemple illustré les vias traversants 451v, 452v connectent le composant 23 à base de matériaux III-V. D'autres vias 453v, 454v connectent le composant 123 à base de silicium. Selon une possibilité, le ou les niveaux d'interconnexions peuvent être rapportés sur la couche optique 122 par l'intermédiaire d'un interposeur à base de silice. Ce niveau d'interconnexions est typiquement faiblement conducteur thermique.

Le procédé permet ainsi de former une architecture optimisée pour la dissipation thermique, comprenant en empilement selon z :
- le substrat 3 massif à base de silicium permettant d'évacuer la chaleur produite par le composant 23,
- une éventuelle couche de conduction thermique 253,
- une couche de contacts 250,
- un niveau III-V comprenant le composant 23 et la structure de dissipation thermique 24,
- la couche optique 122 comprenant le guide d'onde 120 couplé optiquement au composant 23,
- un niveau d'interconnexion 4.

Le procédé selon l'invention permet ainsi d'intégrer verticalement des structures photoniques en silicium obtenues par des procédés standards, avec des composants III-V obtenus par des techniques avancées de recroissance épitaxiale de matériaux III-V. Avantageusement, la ou les croissances épitaxiales nécessitant de hautes températures supérieures à 600°C sont d'abord effectuées, puis l'empilement est retourné de façon à effectuer les étapes standard de la technologie silicium.

La chaleur produite par le composant III-V est typiquement évacuée via la structure de dissipation 24 et le substrat 3, à l'opposé du guide d'onde 120 et/ou du niveau d'interconnexions. Les propriétés optiques du guide d'onde 120 ne sont ainsi pas affectées par le flux de chaleur. Le niveau d'interconnexions forme en outre une barrière thermique isolant les niveaux supérieurs, par exemple un niveau comprenant une électronique de commande. Le composant 23 et son électronique de commande peuvent ainsi être isolés thermiquement l'un de l'autre par le niveau d'interconnexions.

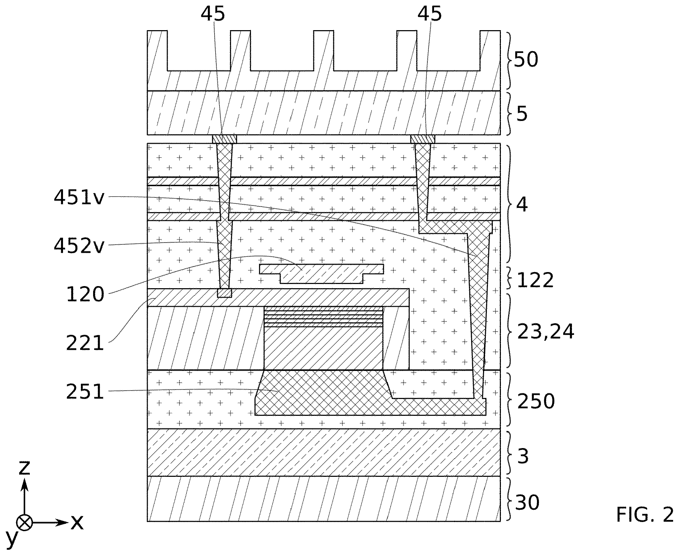

La figure 2 illustre un autre exemple d'architecture obtenue par ce procédé. Dans cet exemple, la couche 221 s'étend latéralement depuis le composant 23 de façon dissymétrique par rapport aux flancs du composant 23. Cela permet par exemple de faciliter la formation du via 451v.

Une électronique de commande 5 peut être assemblée au niveau d'interconnexion 4 par des plots de contacts 45. Un radiateur 50 peut être disposé sur l'électronique de commande 5 pour évacuer la chaleur produite par cette électronique de commande 5. Un dispositif 30, par exemple un dissipateur thermique ou un Peltier, peut être ajouté du côté du substrat 3 de façon à améliorer l'évacuation de la chaleur produite par le composant 23. La partie de couche d'encapsulation intercalée entre le substrat 3 et le contact P 251 est avantageusement fine, et présente typiquement une épaisseur inférieure ou égale à 500 nm, de préférence inférieure à 200 nm.

Les architectures d'hétéro-intégration III-V/Silicium proposées ici permettent notamment :
- Une meilleure dissipation de la chaleur des composants III-V, et une isolation thermique vis-à-vis de l'électronique de commande et/ou du guide d'onde à base de silicium,
- Une compatibilité avec les technologies BEOL CMOS standard,
- Une compatibilité avec les techniques de recroissance avancées (de type SAG et/ou SIBH).

L'invention n'est pas limitée aux modes de réalisations précédemment décrits.

## Revendications

1. Procédé d'intégration sur silicium d'un composant (23) à base de matériau III-V, dit composant III-V, comprenant au moins les étapes suivantes :
- Fournir un premier substrat (1) comprenant une couche optique (122) à base de silicium, ladite couche optique (122) comprenant au moins un guide d'onde (120),
- Reporter un deuxième substrat (2) à base de matériau III-V sur la couche optique (122),
- Former le composant III-V (23) à partir dudit deuxième substrat (2), à proximité du guide d'onde (120) de sorte à permettre un couplage entre le guide d'onde (120) et ledit composant III-V (23), et en conservant une couche (221) à base de matériau III-V s'étendant latéralement depuis le composant III-V (23),
- Former par épitaxie à partir de ladite couche (221) à base de matériau III-V, une structure (24) à base d'InP:Fe bordant latéralement le composant III-V (23),
- Former une couche (250) comprenant des contacts (251, 252), dits contacts III-V, destinés à contacter électriquement le composant III-V (23), sur une face (230) du composant III-V opposée à la couche optique (122),
- Reporter un troisième substrat (3) à base de silicium sur ladite couche (250) comprenant les contacts III-V.

2. Procédé d'intégration selon la revendication précédente comprenant en outre, après report du troisième substrat (3) à base de silicium, les étapes suivantes :
- Retirer le premier substrat (1) en conservant la couche optique (122),
- Former au moins un niveau (4) d'interconnexions sur la couche optique (122), ledit niveau (4) d'interconnexions comprenant des interconnexions (451v, 452v) connectant électriquement les contacts III-V (251, 252).

3. Procédé d'intégration selon la revendication précédente dans lequel le retrait du premier substrat (1) est effectué de façon à exposer la couche optique (122), le procédé comprenant en outre, après retrait du premier substrat (1), un dopage d'une zone (I) à base de silicium de la couche optique (122), par exemple par implantation d'espèces dopantes.

4. Procédé d'intégration selon la revendication précédente comprenant en outre, avant implantation d'espèces dopantes, au moins une autre étape effectuée à une température supérieure ou égale à 600°C.

5. Procédé d'intégration selon l'une quelconque des revendications 2 à 4 dans lequel le premier substrat (1) est un substrat du type semiconducteur sur isolant, comprenant une couche (11) d'oxyde enterrée entre une première partie (10) massive en silicium et une deuxième partie (12) mince à base d'un semiconducteur, et dans lequel le retrait du premier substrat (1) est configuré pour retirer la première partie (10) massive et la couche (11) d'oxyde enterrée.

6. Procédé d'intégration selon l'une quelconque des revendications précédentes dans lequel la formation du composant III-V (23) comprend :
- Un amincissement du deuxième substrat (2) à base de matériau III-V de sorte à conserver une couche (22) de germination à base de matériau III-V,
- Une formation du composant III-V (23) par épitaxie localisée sur une partie seulement de la couche (22) de germination.

7. Procédé d'intégration selon l'une quelconque des revendications 1 à 5 dans lequel la formation du composant III-V (23) comprend :
- Un amincissement du deuxième substrat (2) à base de matériau III-V de sorte à conserver une couche (22) de germination à base de matériau III-V,
- Une formation par épitaxie d'un empilement de couches (221b, 222, 223) fonctionnelles à base de matériau III-V, sur la couche (22) de germination,
- Une gravure d'une partie de l'empilement de sorte à former le composant III-V (23) et la couche (221) à base de matériau III-V s'étendant latéralement depuis le composant III-V (23).

8. Procédé d'intégration selon l'une quelconque des deux revendications précédentes dans lequel le deuxième substrat (2) à base de matériau III-V comprend une couche (21) sacrificielle intercalée entre une partie (20) dite massive du deuxième substrat (2) et une partie (22) destinée à former la couche de germination, et dans lequel l'amincissement comprend :
- Au moins l'un parmi un rognage mécanique de la partie massive (20) du deuxième substrat (2) et/ou une gravure chimique sélective de la partie massive (20) du deuxième substrat (2) vis-à-vis de la couche (21) sacrificielle,
- Une gravure sélective de la couche (21) sacrificielle vis-à-vis de la couche (22) destinée à former la couche de germination.

9. Procédé d'intégration selon l'une quelconque des revendications précédentes dans lequel la formation du composant III-V (23) comprend une formation de puits quantiques (222) à base d'un alliage AlInGaAs ou GalnAsP.

10. Procédé d'intégration selon l'une quelconque des revendications précédentes comprenant en outre, avant report du troisième substrat (3), une formation d'une couche (253) de conduction thermique sur l'un au moins parmi la couche (250) comprenant les contacts III-V et le troisième substrat (3), de façon à intercaler ladite couche (253) de conduction thermique entre le troisième substrat (3) et la couche (250) comprenant les contacts III-V.

11. Procédé d'intégration selon l'une quelconque des revendications précédentes dans lequel la couche (221) à base de matériau III-V s'étendant latéralement depuis le composant III-V est à base d'InP dopé N.

12. Système d'intégration comprenant, en empilement selon une direction z :
- Un substrat (3) à base de silicium
- Une couche (250) comprenant des contacts, dits contacts III-V, destinés à contacter électriquement un composant à base de matériau III-V, dit composant III-V (23),
- Le composant III-V bordé latéralement par une structure (24) à base d'InP:Fe
- Une couche (122) à base de matériau III-V couvrant le composant III-V et la structure à base d'InP:Fe,
- Une couche optique à base de silicium comprenant un guide d'onde (120) couplé au composant III-V.

13. Système d'intégration selon la revendication précédente comprenant en outre, sur la couche optique à base de silicium, Un niveau d'interconnexions comprenant une première partie d'interconnexions connectant électriquement les contacts III-V, et une deuxième partie d'interconnexions destinée à connecter des composants à base de silicium disposés sur ledit niveau d'interconnexions.

14. Système d'intégration selon l'une quelconque des revendications 12 à 13 dans lequel la couche optique comprend en outre au moins un autre composant à base de silicium, par exemple un modulateur de phase à jonction PN, connecté au niveau d'interconnexions.

15. Système d'intégration selon l'une quelconque des revendications 12 à 14 dans lequel la couche à base de matériau III-V couvrant le composant III-V est à base d'InP dopé N, et dans lequel le composant III-V comprend une partie à base d'InP dopé P, et des puits quantiques à base d'un alliage AlInGaAs ou GaInAsP intercalés entre la partie à base d'InP dopé P et la couche à base d'InP dopé N.

## Patentansprüche

1. Verfahren zur Integration auf Silizium einer Komponente (23) auf Basis von III-V-Material, III-V-Komponente genannt, das mindestens die folgenden Schritte umfasst:
- Bereitstellen eines ersten Substrats (1), das eine optische Schicht (122) auf Siliziumbasis umfasst, wobei die optische Schicht (123) mindestens einen Wellenleiter (120) umfasst,
- Übertragen eines zweiten Substrats (2) auf Basis von III-V-Material auf die optische Schicht (122),
- Bilden der III-V-Komponente (23) ausgehend von dem zweiten Substrat (2) in der Nähe des Wellenleiters (120) derart, dass eine Kopplung zwischen dem Wellenleiter (120) und der III-V-Komponente (23) erlaubt wird, und unter Beibehalten einer Schicht (221) auf Basis von III-V-Material, die sich seitlich ausgehend von der III-V-Komponente (23) erstreckt,
- Epitaktisches Bilden ausgehend von der Schicht (221) auf Basis von III-V-Material einer Struktur (24) auf Basis von InP:Fe, die seitlich an die III-V-Komponente (23) begrenzt,
- Bilden einer Schicht (250), die Kontakte (251, 252), III-V-Kontakte genannt, umfasst, die dazu bestimmt sind, die III-V-Komponente (23) elektrisch auf einer Fläche (230) der III-V-Komponente, der optischen Schicht (122) entgegengesetzt, zu kontaktieren,
- Übertragen eines dritten Substrats (3) auf Siliziumbasis auf die Schicht (250), die die III-V-Kontakte umfasst.

2. Verfahren zur Integration nach dem vorstehenden Anspruch, das außerdem nach dem Übertragen des dritten Substrats (3) auf Siliziumbasis die folgenden Schritte umfasst:
- Entfernen des ersten Substrats (1) unter Beibehalten der optischen Schicht (122),
- Bilden mindestens einer Ebene (4) von Zwischenverbindungen auf der optischen Schicht (122), wobei die Ebene (4) von Zwischenverbindungen Zwischenverbindungen (451v, 452v) umfasst, die die III-V-Kontakte (251, 252) elektrisch verbinden.

3. Verfahren nach dem vorstehenden Anspruch, wobei das Entfernen des ersten Substrats (1) derart erfolgt, dass die optische Schicht (122) freigelegt wird, wobei das Verfahren außerdem nach dem Entfernen des ersten Substrats (1) eine Dotierung einer Zone (I) auf Siliziumbasis der optischen Schicht (122) beispielsweise durch Implantation von Dotierungsspezies umfasst.

4. Verfahren zur Integration nach dem vorstehenden Anspruch, das außerdem vor der Implantation von Dotierungsspezies mindestens einen anderen Schritt umfasst, der bei einer Temperatur größer oder gleich 600 °C erfolgt.

5. Verfahren zur Integration nach einem der Ansprüche 2 bis 4, wobei das erste Substrat (1) ein Substrat vom Typ Halbleiter-auf-Isolator ist, das eine Oxidschicht (11) umfasst, die zwischen einem ersten massiven Teil (10) aus Silizium und einem zweiten dünnen Teil (12) auf Basis eines Halbleiters vergraben ist, und wobei das Entfernen des ersten Substrats (1) dazu konfiguriert ist, den ersten massiven Teil (10) und die vergrabene Oxidschicht (11) zu entfernen.

6. Verfahren zur Integration nach einem der vorstehenden Ansprüche, wobei die Bildung der III-V-Komponente (23) Folgendes umfasst:
- Eine Verdünnung des zweiten Substrats (2) auf Basis von III-V-Material derart, dass eine Keimschicht (22) auf Basis von III-V-Material behalten wird,
- Eine Bildung der III-V-Komponente (23) durch Epitaxie auf nur einem Teil der Keimschicht (22) lokalisiert.

7. Verfahren zur Integration nach einem der Ansprüche 1 bis 5, wobei die Bildung der III-V-Komponente (23) Folgendes umfasst:
- Eine Verdünnung des zweiten Substrats (2) auf Basis von III-V-Material derart, dass eine Keimschicht (22) auf Basis von III-V-Material behalten wird,
- Eine Bildung durch Epitaxie einer Stapelung von Funktionsschichten (221b, 222, 223) auf Basis von III-V-Material auf der Keimschicht (22),
- Eine Ätzung eines Teils der Stapelung derart, dass die III-V-Komponente (23) gebildet wird und sich die Schicht (221) auf Basis von III-V-Material seitlich ausgehend von der III-V-Komponente (23) erstreckt.

8. Verfahren zur Integration nach einem der zwei vorstehenden Ansprüche, wobei das zweite Substrat (2) auf Basis von III-V-Material eine Opferschicht (21) umfasst, die zwischen einem massiv genannten Teil (20) des zweiten Substrats (2) und einem Teil (22), der dazu bestimmt ist, die Keimschicht zu bilden, eingefügt ist, und wobei die Verdünnung Folgendes umfasst:
- Mindestens eines aus einem mechanischen Beschneiden des massiven Teils (20) des zweiten Substrats (2) und/oder einer selektiven chemischen Ätzung des massiven Teils (20) des zweiten Substrats (2) gegenüber der Opferschicht (21),
- Eine selektive Ätzung der Opferschicht (21) gegenüber der Schicht (22), die dazu bestimmt ist, die Keimschicht zu bilden.

9. Verfahren zur Integration nach einem der vorstehenden Ansprüche, wobei die Bildung der III-V-Komponente (23) eine Bildung von Quantentöpfen (222) auf Basis einer AlInGaAs-oder GaInAsP-Legierung umfasst.

10. Verfahren zur Integration nach einem der vorstehenden Ansprüche, das außerdem vor dem Übertragen des dritten Substrats (3) eine Bildung einer Wärmeleitungsschicht (253) auf einer mindestens der Schicht (250), die die III-V-Kontakte umfasst, und dem dritten Substrat (3), derart umfasst, dass die Wärmeleitungsschicht (253) zwischen dem dritten Substrat (3) und der Schicht (250), die die III-V-Kontakte umfasst, eingefügt ist.

11. Verfahren zur Integration nach einem der vorstehenden Ansprüche, wobei sich die Schicht (221) auf Basis von III-V-Material, die sich seitlich ausgehend von der III-V-Komponente erstreckt, aus N-dotiertem InP ist.

12. System zur Integration, das in Stapelung gemäß einer z-Richtung von Folgendem umfasst:
- Ein Substrat (3) auf Siliziumbasis,
- Eine Schicht (250), die Kontakte, III-V-Kontakte genannt, umfasst, die dazu bestimmt sind, eine Komponente auf Basis von III-V-Material, III-V-Komponente (23) genannt, zu kontaktieren,
- Die III-V-Komponente, die seitlich von einer Struktur (24) auf Basis von InP:Fe begrenzt ist,
- Eine Schicht (122) auf Basis von III-V-Material, die die III-V-Komponente und die Struktur auf Basis von InP:Fe bedeckt,
- Eine optische Schicht auf Siliziumbasis, die einen Wellenleiter (120), der mit der III-V-Komponente gekoppelt ist, umfasst.

13. System zur Integration nach dem vorstehenden Anspruch, das außerdem auf der optischen Schicht auf Siliziumbasis eine Ebene von Zwischenverbindungen umfasst, die einen ersten Teil von Zwischenverbindungen umfasst, der die III-V-Kontakte elektrisch verbindet, und einen zweiten Teil von Zwischenverbindungen, der dazu bestimmt ist, Komponenten auf Siliziumbasis, die auf dem Zwischenverbindungsniveau, die auf der Ebene von Zwischenverbindungen angeordnet sind, zu verbinden.

14. System zur Integration nach einem der Ansprüche 12 bis 13, wobei die optische Schicht außerdem mindestens eine andere Komponente auf Siliziumbasis umfasst, beispielsweise einen PN-Übergangs-Phasenmodulator, der auf dem Zwischenverbindungsniveau verbunden ist.

15. System zur Integration nach einem der Ansprüche 12 bis 14, wobei die Schicht auf Basis von III-V-Material, die die III-V-Komponente abdeckt, auf Basis von N-dotiertem InP ist, und wobei die III-V-Komponente einen Teil auf Basis von P-dotiertem InP und Quantentöpfe auf Basis einer AlInGaAs-oder GaInAsP-Legierung, die zwischen dem Teil auf Basis von P-dotiertem InP und der Schicht auf Basis von N-dotiertem InP eingefügt sind, umfasst.

## Claims

1. Method for integrating on silicon, a component (23) with the basis of III-V material, called III-V component, comprising at least the following steps:
- Providing a first substrate (1) comprising a silicon-based optical layer (122), said optical layer (122) comprising at least one waveguide (120),
- Transferring a second substrate (2) with the basis of III-V material onto the optical layer (122),
- Forming the III-V component (23) from said second substrate (2), in the proximity of the waveguide (120) so as to enable a coupling between the waveguide (120) and said III-V component (23) and by preserving a layer (221) with the basis of III-V material laterally extending from the III-V component (23),
- Forming, by epitaxy, from said layer (221) with the basis of III-V material, an InP:Fe-based structure (24) laterally bordering the III-V component (23),
- Forming a layer (250) comprising contacts (251, 252), called III-V contacts, intended to electrically contact the III-V component (23), on a face (230) of the III-V component opposite the optical layer (122),
- Transferring a third silicon-based substrate (3) onto said layer (250) comprising the III-V contacts.

2. Integration method according to the preceding claim, further comprising, after transfer of the third silicon-based substrate (3), the following steps:
- Removing the first substrate (1) by preserving the optical layer (122),
- Forming at least one interconnecting level (4) on the optical layer (122), said interconnecting level (4) comprising interconnections (451v, 452v) electrically connecting the III-V contacts (251, 252).

3. Integration method according to the preceding claim, wherein the removal of the first substrate (1) is done so as to expose the optical layer (122), the method further comprising, after removal of the first substrate (1), a doping of a silicon-based zone (I) of the optical layer (122), for example by implantation of doping species.

4. Integration method according to the preceding claim, further comprising, before implantation of doping species, at least one other step carried out at a temperature greater than or equal to 600°C.

5. Integration method according to any one of claims 2 to 4, wherein the first substrate (1) is a substrate of the semiconductor on insulator type, comprising an oxide layer (11) buried between a first silicon massive part (10) and a second thin part (12) with the basis of a semiconductor, and wherein the removal of the first substrate (1) is configured to remove the first massive part (10) and the buried oxide layer (11).

6. Integration method according to any one of the preceding claims, wherein the formation of the III-V component (23) comprises:
- A thinning of the second substrate (2) with the basis of III-V material so as to preserve a germination layer (22) with the basis of III-V material,
- A formation of the III-V component (23) by localised epitaxy on only some of the germination layer (22).

7. Integration method according to any one of claims 1 to 5, wherein the formation of the III-V component (23) comprises:
- A thinning of the second substrate (2) with the basis of III-V material so as to preserve a germination layer (22) with the basis of III-V material,
- A formation by epitaxy of a stack of functional layers (221b, 222, 223) with the basis of III-V material, on the germination layer (22),
- An etching of a part of the stack so as to form the III-V component (23) and the layer (221) with the basis of III-V material laterally extending from the III-V component (23).

8. Integration method according to any one of the two preceding claims, wherein the second substrate (2) with the basis of III-V material comprises a sacrificial layer (21) inserted between a so-called massive part (20) of the second substrate (2) and a part (22) intended to form the germination layer, and wherein the thinning comprises:
- At least one from among a mechanical cropping of the massive part (20) of the second substrate (2) and/or a selective chemical etching of the massive part (20) of the second substrate (2) with respect to the sacrificial layer (21),
- A selective etching of the sacrificial layer (21) with respect to the layer (22) intended to form the germination layer.

9. Integration method according to any one of the preceding claims, wherein the formation of the III-V component (23) comprises a formation of quantum wells (222) with the basis of an AllnGaAs or GalnAsP alloy.

10. Integration method according to any one of the preceding claims, further comprising, before transfer of the third substrate (3), a formation of a thermal conduction layer (253) on the at least one from among the layer (250) comprising the III-V contacts and the third substrate (3), so as to insert said thermal conduction layer (253) between the third substrate (3) and the layer (250) comprising the III-V contacts.

11. Integration method according to any one of the preceding claims, wherein the layer (221) with the basis of III-V material laterally extending from the III-V component is N doped InP-based.

12. Integration system comprising, stacked in a direction z:
- A silicon-based substrate (3),
- A layer (250) comprising contacts, called III-V contacts, intended to electrically contact a component with the basis of III-V material, called III-V component (23),
- The III-V component laterally bordered by an InP:Fe-based structure (24),
- A layer (122) with the basis of III-V material covering the III-V component and the Inp:Fe-based structure,
- A silicon-based optical layer comprising a waveguide (120) coupled to the III-V component.

13. Integration system according to the preceding claim, further comprising, on the silicon-based optical layer, an interconnecting level comprising a first interconnecting part electrically connecting the III-V contacts, and a second interconnecting part intended to connect silicon-based components disposed on said interconnecting level.

14. Integration system according to any one of claims 12 to 13, wherein the optical layer further comprises at least one other silicon-based component, for example a PN junction phase modulator, connected to the interconnecting level.

15. Integration system according to any one of claims 12 to 14, wherein the layer with the basis of III-V material covering the III-V component is N doped InP-based, and wherein the III-V component comprises a P doped InP-based part, and quantum wells with the basis of an AllnGaAs or GalnAsP alloy inserted between the P doped InP-based part and the N doped InP-based layer.
